# EUROPEAN PATENT APPLICATION

(11) **EP 4 089 900 A1**
(43) Date of publication of application: **16.11.2022**
(21) Application number: 22172955.1
(22) Date of filing: 12.05.2022
(51) Int. Cl.: H02M 1/00, H02M 3/158, H02M 1/32

(54) **SYSTEMS AND METHODS FOR CURRENT SENSING AND CONTROL FOR MULTIPHASE POWER CONVERTERS**

(30) Priority: 14.05.2021 US 202163201827 P
(71) Applicant: Carrier Corporation, Palm Beach Gardens, FL 33418 (US)
(72) Inventor: SHE, Xu, Bloomfield (US); LIAO, XuQiang, Syracuse (US); SHIN, Jaegue, Bloomfield (US); AGIRMAN, Ismail, Bloomfield (US); GINSBERG, David, Bloomfield (US)
(74) Representative: Dehns

(57) **Abstract**

A multiphase converter (100) is disclosed. The multiphase converter (100) comprises multiple phase legs. Each leg has a combination of power semiconductors. The multiphase converter (100) further comprises a terminal current sensor (130) configured to generate output signals indicating a terminal current (160) flowing through the multiphase converter (100). The multiphase converter (100) further comprises a plurality of current sensors (134, 136, 138) configured to generate output signals indicating low side switch phase current of each phase leg. The multiphase converter (100) further comprises a low pass filter (142) for filtering out high frequency component of the low side switch current signal for each phase leg.

## Description

The invention relates generally to multiphase power converters and, more specifically, to current sensing and control for multiphase power converters.

In multiphase power converters, large current ripple exists in each phase although the total current has a relatively small ripple component. In order to control the total terminal current as well as ensure the current balance among phases, high performance digital sampling, control, and protection strategy is needed. Typically, the high ripple current in the phase current is difficult to be sampled accurately by digital signal processors.

Aspects of the disclosure relate to methods, apparatuses, and/or systems for current sensing and control for multiphase power converters.

According to a first aspect, a multiphase converter is provided. The multiphase converter comprises multiple phase legs. Each leg has a combination of power semiconductors. The multiphase converter further comprises a terminal current sensor configured to generate output signals indicating a terminal current flowing through the multiphase converter. The multiphase converter further comprises a plurality of current sensors configured to generate output signals indicating low side switch phase current of each phase leg. The multiphase converter further comprises a low pass filter for filtering out high frequency component of the low side switch current signal for each phase leg.

Optionally, the terminal current sensor and/or the plurality of current sensors are resistor-based sensors.

Optionally, the plurality of current sensors are coupled to an output node of each phase leg.

Optionally, the multiphase converter comprises an over current protection device. The over current protection device is configured to limit the low side switch phase currents based on the low side switch current signals.

Optionally, the multiphase converter comprises a system controller configured to regulate a total amount of current flowing into or out of the system based on the output signals from the terminal current sensor.

Optionally, the multiphase converter comprises an analog to digital conversion device configured to provide analog to digital conversion of the filtered low side switch signals.

Optionally, the multiphase converter comprises a current balance controller configured to control balance of the phase current based on the digitized filtered low side switch signals.

According to another aspect, a method for current sensing in a multiphase converter is provided. The method comprises generating, with a terminal current sensor, output signals indicating a terminal current flowing through a multiphase converter having multiple phase legs. The method further comprises generating, with a plurality of current sensors, output signals indicating low side switch phase current of each phase leg. The method further comprises filtering out, with a low pass filter, high frequency component of the low side switch current signal for each phase leg.

Optionally, the method further comprises generating the output signals indicating the low side switch phase current of each phase leg and/or the terminal current with resistor-based sensors.

Optionally, the method further comprises coupling the plurality of current sensors to an output node of each phase leg.

Optionally, the method further comprises regulating a total amount of current flowing into or out of the system based on the output signals from the terminal current sensor.

Optionally, the method further comprises limiting the low side switch phase currents based on the low side switch current signals.

Optionally, a current sensing system is provided. The system comprises a terminal current sensor configured to generate output signals indicating a terminal current flowing through a multiphase converter having multiple phase legs. The system further comprises a plurality of current sensors configured to generate output signals indicating low side switch phase current of each phase leg, wherein the plurality of current sensors are coupled to an output node of each phase leg.

Optionally, the current sensing system is resistor-based sensors.

Various other aspects, features, and advantages of the invention will be apparent through the detailed description of the invention and the drawings attached hereto. It is also to be understood that both the foregoing general description and the following detailed description are examples and not restrictive of the scope of the invention. Certain exemplary embodiments will now be described in greater detail by way of example only and with reference to the accompanying drawings in which:
FIG. 1 shows an example of a multiphase power converter;
FIG. 2 shows an example of a conventional multiphase power converter;
FIG. 3 shows an example of operation of system 100; and
FIG. 4 shows a chart of a method of current sensing and control in a multiphase power converter.

In the following description, for the purposes of explanation, numerous specific details are set forth in order to provide a thorough understanding of the embodiments of the invention. It will be appreciated, however, by those having skill in the art that the embodiments of the invention may be practiced without these specific details or with an equivalent arrangement. In other cases, well-known structures and devices are shown in block diagram form in order to avoid unnecessarily obscuring the embodiments of the invention.

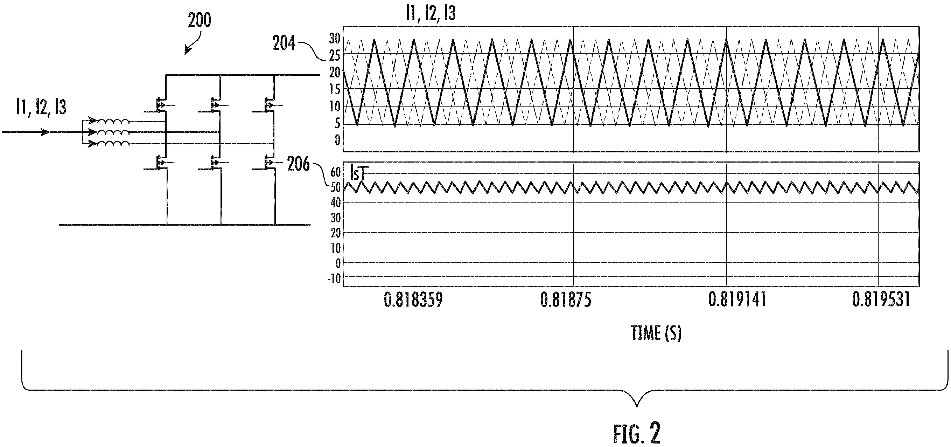

Generally, interleaved multiphase converters may have large current ripple in each inductor current, and a small current ripple in total current. However, if only the total current is sampled, control of the total amount of current flowing into the system may be achieved, but the current may not be balanced among the multiphase inductor currents. If the current of each inductor is sampled, the total cost may be high, and the high ripple current may be difficult to be sampled for analog to digital conversion. FIG.2 shows an example of a conventional multiphase power converter 200. IsT is the total current flowing through the multiphase power converter, and 11, 12, and 13 refer to each inductor current. Waveform 204 shows the large current ripple in each of current I1, I2, and 13. Waveform 206 shows the small current ripple in total current IsT.

The present disclosure, in accordance with some embodiments, describes a multiphase converter that uses a sensing scheme that includes a terminal current sensor and low side bridge current sensors located at the output nodes of each phase leg for a more accurate phase current measurement. In some embodiments, the multiphase converter includes a fast over current protection device and a low bandwidth filter to help remove the low side bridge current ripple such that only low ripple signals are processed by analog to digital conversion, which may impact the dynamic response and stability of the system controller. Accordingly, the present multiphase converter uses a high-performance digital sampling, control, and protection strategy in order to control the total terminal current as well as ensure the current balance among phases.

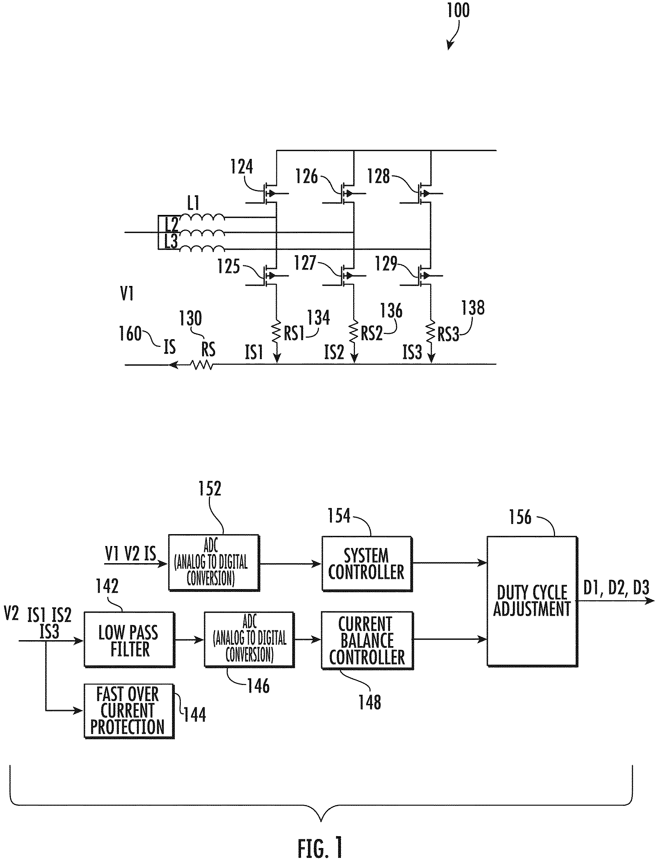

FIG. 1 shows an example of a multiphase converter 100 in accordance with one or more embodiments. In some embodiments, multiphase converter 100 includes a plurality of conversion phases, and each phase may include an inductor and a phase leg having power semiconductors. For example, as shown in FIG.1, a first phase includes inductor L1 and switch (124, 125), a second phase includes inductor L2 and switch (126, 127), and a third phase includes inductor L3 and switch (128, 129). In some embodiments, one or more of the power semiconductors may include insulated gate bipolar transistor (IGBT), metal oxide semiconductor field effect transistor (MOFSET), etc.

In some embodiments, multiphase converter 100 may include a terminal current sensor RS (130). The terminal current sensor RS (130) may be configured to generate output signals indicating a terminal current IS (160) flowing through the multiphase converter. In some embodiments, Current sensor RS (130) may be a resistor. In some embodiments, multiphase converter 100 may include a plurality of current sensors RS1, RS2, and RS3 (134, 136, and 138) configured to generate output signals indicating low side switch phase current IS1, IS2, and IS3 of each phase leg respectively. For example, sensor RS1 senses current Is1 flowing through the low side of power semiconductors (124, 126), etc. In some embodiments, one or more of the plurality of current sensors RS1, RS2, and RS3 (134, 136, and 138) may be coupled to an output node of the respective phase leg. In some embodiments, the current sensors RS1, RS2, and RS3 (134, 136, 138) are resistor-based sensors.

In some embodiments, multiphase converter 100 includes an over current protection device 144. In some embodiments, over current protection device 144 may be configured for detecting an over current condition. In some embodiments, over current protection device 144 may limit the low side switch phase currents responsive to detecting the over current condition. In some embodiments, over current protection device 144 limits the currents based on the generated low side switch current signals. In some embodiments, over current protection device 144 may be configured to monitor low side switch currents Is1, Is2, and Is3 and generate corresponding proportional voltage signals. Responsive to a voltage signal reaching a predetermined threshold value, the over current protection device 144 may generate a current limit control signal to limit the current.

In some embodiments, multiphase converter 100 may include a low pass filter 142 for filtering out high frequency component of the low side switch current signal for each phase leg. For example, low pass filter 142 may be configured to receive current signals Is1, Is2, and Is3 and filter out high frequency component of one or more of the received signals. This may help remove the low side bridge current ripple and allows for an easier analog to digital conversion. The low pass filter may be first order, second order, or other types.

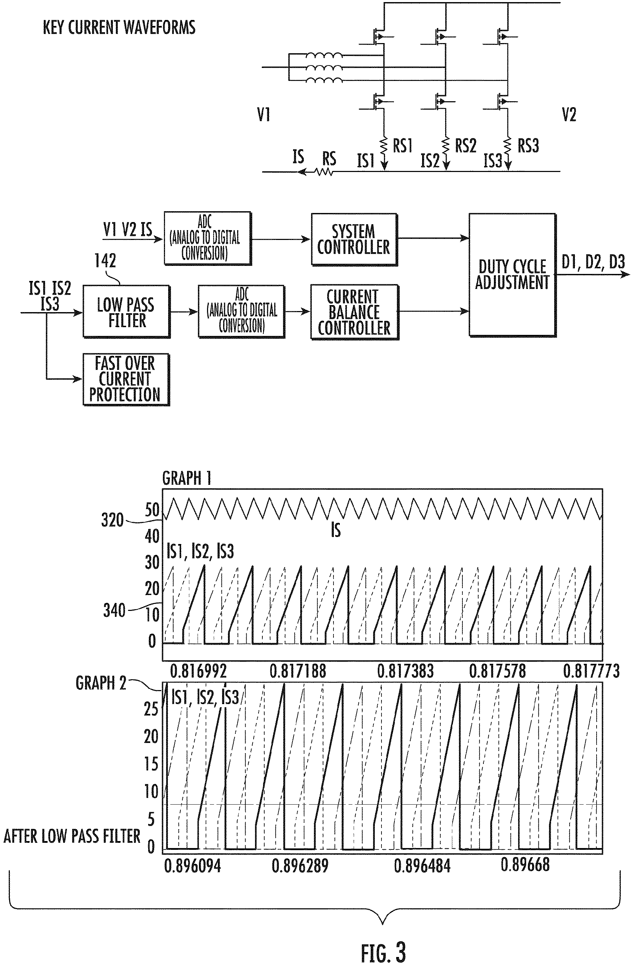

FIG.3 shows an example of operation of multiphase converter 100, according to one or more embodiments. Graph 1 shows the output signals 320 from terminal current sensor RS 130. Terminal current Is shows a low ripple. Graph 1 also shows the output signals 340 from phase current sensors RS1, RS2, and RS3. As can be seen from the graph, the phase current ripple for phase currents Is1, Is2, and Is3 is higher that the terminal current ripple. Graph 2 shows filtered signal 360 of the phase current signals 340 after passing through low pass filter 142. As can be seen from graph 2, the phase current has a much smaller current ripple 360 when compared to the obtained signal 340 before the low pass filtering.

In some embodiments, multiphase converter 100 may include an analog to digital converter ADC 146 configured to provide analog to digital conversion the filtered low side switch signals. Digital converter ADC 146 may be configured to receive low ripple signals (filtered low side switch signals) from low pass filter 142. The filtered received signals are sampled and digitized by digital converter 146. This ADC could either be an external integrated circuit or ADC module of a digital signal processor.

In some embodiments, multiphase converter 100 may include a current balance controller 148. The current balance controller may be configured to control balance of phase current Is1, Is2, and Is3 based on the digitized filtered low side switch signals. The current balance controller may be configured to detect the difference among phase current and generate signals that modify the control signal generated from system controller for each phase. This may ensure that the converge of phase current is in a balanced condition.

In some embodiments, multiphase converter 100 may include an analog to digital converter ADC 152. Digital converter ADC 152 is configured to receive input voltage VI, output voltage V2, and terminal current Is for analog to digital conversion.

In some embodiments, multiphase converter 100 may include a system controller 154. The system controller may be configured to regulate a total amount of current flowing into or out of the system. Control operations of the system controller may be based the output signals from the terminal current sensor RS (130) received from digital converter 152. For instance, the controller may compare the measured terminal voltage or current with the reference voltage or current and feed the difference to a proportion-integral regulator. This regulator will generate the duty cycle that eliminate the difference between reference and feedback.

In some embodiments, multiphase converter 100 may include duty cycle adjustment device 156 for controlling the output voltage. Duty cycle adjustment may be based on controls from system controller 154 and current balance controller 148. For instance, the output of current balance controller will be added to or subtracted from the output of system controller, depending on the operating condition.

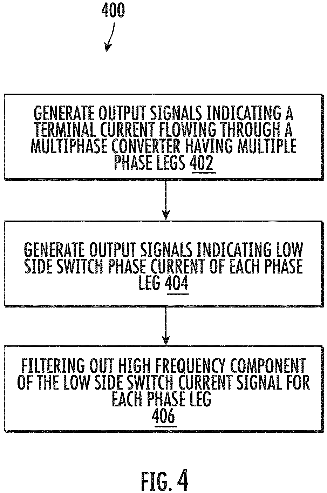

FIG.4 Illustrates a method 400 for sensing and controlling current in a multiphase converter, in accordance with one or more embodiments of the present disclosure.

At an operation 402 of method 400, output signals indicating a terminal current flowing through a multiphase converter having multiple phase legs is generated. In some embodiments, output signals indicating the terminal current is generated with resistor-based sensor. In some embodiments, operation 402 may be performed by a sensor, the same as or similar to sensor RS (130) (shown in FIG.1 and described herein).

At an operation 404 of method 400, output signals indicating low side switch phase current of each phase leg are generated. In some embodiments, output signals indicating the low side phase currents may be generated with resistor-based current sensors. In some embodiments, operation 404 may be performed by a plurality of current sensors, the same as or similar to current sensors RS 1, RS2, and RS3 (134, 136, 138) (shown in FIG.1 and described herein).

At an operation 406 of method 400, high frequency component of the low side switch current signal for each phase leg are filtered. In some embodiments, operation 406 may be performed by a low pass filter, the same as or similar to low pass filter 142 (shown in FIG. 1 and described herein).

It should be understood that the description and the drawings are not intended to limit the invention to the particular form disclosed, but to the contrary, the intention is to cover all modifications, equivalents, and alternatives falling within the spirit and scope of the present invention as defined by the appended claims. Further modifications and alternative embodiments of various aspects of the invention will be apparent to those skilled in the art in view of this description. Accordingly, this description and the drawings are to be construed as illustrative only and are for the purpose of teaching those skilled in the art the general manner of carrying out the invention. It is to be understood that the forms of the invention shown and described herein are to be taken as examples of embodiments. Elements and materials may be substituted for those illustrated and described herein, parts and processes may be reversed or omitted, and certain features of the invention may be utilized independently, all as would be apparent to one skilled in the art after having the benefit of this description of the invention. Changes may be made in the elements described herein without departing from the spirit and scope of the invention as described in the following claims. Headings used herein are for organizational purposes only and are not meant to be used to limit the scope of the description.

As used throughout this application, the word "may" is used in a permissive sense (i.e., meaning having the potential to), rather than the mandatory sense (i.e., meaning must). The words "include", "including", and "includes" and the like mean including, but not limited to. As used throughout this application, the singular forms "a," "an," and "the" include plural referents unless the content explicitly indicates otherwise. Thus, for example, reference to "an element" or "a element" includes a combination of two or more elements, notwithstanding use of other terms and phrases for one or more elements, such as "one or more." The term "or" is, unless indicated otherwise, non-exclusive, i.e., encompassing both "and" and "or." Terms describing conditional relationships, e.g., "in response to X, Y," "upon X, Y,", "if X, Y," "when X, Y," and the like, encompass causal relationships in which the antecedent is a necessary causal condition, the antecedent is a sufficient causal condition, or the antecedent is a contributory causal condition of the consequent, e.g., "state X occurs upon condition Y obtaining" is generic to "X occurs solely upon Y" and "X occurs upon Y and Z." Such conditional relationships are not limited to consequences that instantly follow the antecedent obtaining, as some consequences may be delayed, and in conditional statements, antecedents are connected to their consequents, e.g., the antecedent is relevant to the likelihood of the consequent occurring. Further, unless otherwise indicated, statements that one value or action is "based on" another condition or value encompass both instances in which the condition or value is the sole factor and instances in which the condition or value is one factor among a plurality of factors. Unless otherwise indicated, statements that "each" instance of some collection have some property should not be read to exclude cases where some otherwise identical or similar members of a larger collection do not have the property, i.e., each does not necessarily mean each and every.

The following clauses recite features of the invention which may or may not presently be claimed, but which may serve as basis for amendments and/or one or more divisional applications:
1. A current sensing system comprising: a terminal current sensor configured to generate output signals indicating a terminal current flowing through a multiphase converter having multiple phase legs; and a plurality of current sensors configured to generate output signals indicating low side switch phase current of each phase leg, wherein the plurality of current sensors are coupled to an output node of each phase leg.
2. The current sensing system of clause 1, further comprising: a low pass filter for filtering out high frequency component of the low side switch current for each phase leg.
3. The current sensing system of any preceding clause, wherein the current sensing comprises resistor-based sensors.
4. The current sensing system of any preceding clause, further comprising: an over current protection device, wherein the over current protection device is configured to limit the low side switch phase currents based on the low side switch current signals.
5. The current sensing system of any preceding clause, further comprising: an analog to digital conversion device, wherein the analog to digital conversion device is configured to provide analog to digital conversion the filtered low side switch signals.
6. The current sensing system of any preceding clause, further comprising: a current balance controller, wherein the current balance controller is configured to control balance of the phase current based on the digitized filtered low side switch current signals.

## Claims

1. A multiphase converter (100) comprising:
multiple phase legs, wherein each leg has a combination of power semiconductors;
a terminal current sensor (130) configured to generate output signals indicating a terminal current (160) flowing through the multiphase converter (100);
a plurality of current sensors (134, 136, 138) configured to generate output signals indicating low side switch phase current of each phase leg; and
a low pass filter (142) for filtering out high frequency component of the low side switch current signal for each phase leg.

2. The multiphase converter (100) of claim 1, wherein the terminal current sensor (130) and/or the plurality of current sensors (134, 136, 138) are resistor-based sensors.

3. The multiphase converter (100) of claim 1 or 2, wherein the plurality of current sensors (134, 136, 138) are coupled to an output node of each phase leg.

4. The multiphase converter (100) of claim 1, 2 or 3, further comprising:
an over current protection device (144), wherein the over current protection device (144) is configured to limit the low side switch phase currents based on the low side switch current signals.

5. The multiphase converter of any preceding claim, further comprising:
a system controller (154) configured to regulate a total amount of current flowing into or out of the system based on the output signals from the terminal current sensor (130).

6. The multiphase converter (100) of any preceding claim, further comprising:
an analog to digital conversion device (146), wherein the analog to digital conversion device (146) is configured to provide analog to digital conversion of the filtered low side switch signals.

7. The multiphase converter of claim 6, further comprising:
a current balance controller (148), wherein the current balance controller (148) is configured to control balance of the phase current based on the digitized filtered low side switch signals.

8. A method comprising:
generating, with a terminal current sensor (130), output signals indicating a terminal current (160) flowing through a multiphase converter (100) having multiple phase legs;
generating, with a plurality of current sensors (134, 136, 138), output signals indicating low side switch phase current of each phase leg; and
filtering out, with a low pass filter (142), high frequency component of the low side switch current signal for each phase leg.

9. The method of claim 8, wherein the output signals indicating the low side switch phase current of each phase leg and/or the terminal current (160) are generated with resistor-based sensors.

10. The method of claim 8 or 9, further comprising:
coupling the plurality of current sensors (134, 136, 138) to an output node of each phase leg.

11. The method of claim 8 ,9 or 10, further comprising:
receiving, with a fast over current protection device (144), the low side switch current signals; and
limiting the low side switch phase currents based on the received low side switch current signals.

12. The method of any of claims 8 to 11, further comprising:
regulating a total amount of current flowing into or out of the system based on the output signals from the terminal current sensor (130).

13. The method of any of claims 8 to 12, further comprising:
digitizing, using an analog to digital conversion device (146), the filtered low side switch signals.

14. The method of claim 13, further comprising:
controlling balance of the phase current based on the digitized filtered low side switch current signals.
